# EUROPEAN PATENT APPLICATION

(11) **EP 3 413 358 A1**
(43) Date of publication of application: **12.12.2018**
(21) Application number: 17746891.5
(22) Date of filing: 24.01.2017
(51) Int. Cl.: H01L 31/052

(54) **PHOTOVOLTAIC ASSEMBLY**

(30) Priority: 01.02.2016 CN 201610069481
(71) Applicant: Gree Electric Appliances, Inc. of Zhuhai, Zhuhai, Guangdong 519070 (CN)
(72) Inventor: HUANG, Meng, Zhuhai Guangdong 519070 (CN); LIANG, Rongxin, Zhuhai Guangdong 519070 (CN); REN, Peng, Zhuhai Guangdong 519070 (CN); TANG, Wenqiang, Zhuhai Guangdong 519070 (CN); NAN, Shugong, Zhuhai Guangdong 519070 (CN); LIU, Xia, Zhuhai Guangdong 519070 (CN)
(74) Representative: V.O.
(86) International application number: PCT/CN2017/072413
(87) International publication number: WO 2017/133571

(57) **Abstract**

A photovoltaic assembly, comprising: two layers of glass panels and a cell sheet layer (2) packaged between the two layers of glass panels, wherein a plurality of through holes is provided on the two layers of glass panels and the cell sheet layer (2), so as to form a plurality of fluid passages passing through the whole photovoltaic assembly, and at least some of the through holes are located in clearances formed between cell sheets (21) in the cell sheet layer (2). By providing a plurality of fluid passages passing through a whole photovoltaic assembly formed by packaging a cell sheet layer by two layers of glass panels, the effect of radiating the heat of cell sheets can be achieved and the problem of overheat caused by high temperature of the photovoltaic assembly can be resolved, thereby improving the power generation efficiency and the service life of the photovoltaic assembly.

## Description

The present application claims benefit of China Patent Application No. 201610069481.0, filed on February 1, 2016 and entitled 'Photovoltaic Assembly', the contents of which are hereby incorporated by reference in its entirety.

### Technical Field

The disclosure relates to a photovoltaic technology and in particular to a photovoltaic assembly.

### Background

Solar energy is used as a clean, pollution-free and inexhaustible energy source, and the photovoltaic technology is a technology for converting solar light energy to electric energy. In a photovoltaic field, the photovoltaic assembly is a core part in a solar power generation support. A related double-glass photovoltaic assembly is generally formed by an aluminium frame, tempered glass, Ethylene Vinyl Acetate (EVA), cell sheets, a Tedlar film and so on, the EVA, the cell sheets and the Tedlar film are provided between a tempered glass at a front side and a tempered glass of a backboard, and outer rings of two pieces of the tempered glass are constrained and fixed by the aluminium frame.

The related double-glass photovoltaic assembly has the following disadvantages:
1. The photovoltaic assembly is directly irradiated by sunshine for a long time, such that a backboard glass is seriously heated, and a temperature is excessive, thereby the generating efficiency of the photovoltaic assembly is reduced, and a service life of the photovoltaic assembly is adversely affected;
2. In severe environment conditions, such as strong wind, heavy rain, and heavy snow, a pressure of the photovoltaic assembly cannot be relieved in time, such that the damage is caused, and the service life of the assembly is shortened;
3. Electrons generated by the cell sheets run to a surrounding aluminium frame, such that the generating efficiency of the photovoltaic assembly is reduced.

### Summary

The disclosure aims to provide a photovoltaic assembly, and is capable of improving the generating efficiency of the photovoltaic assembly.

In order to achieve the above objective, the disclosure provides a photovoltaic assembly, including: two layers of glass panels and a cell sheet layer packaged between the two layers of glass panels, wherein a plurality of through holes are provided on the two layers of glass panels and the cell sheet layer, so as to form a plurality of fluid passages passing through the whole photovoltaic assembly, and at least part of the through holes are located in clearances formed between cell sheets in the cell sheet layer.

In an exemplary embodiment, the plurality of through holes form multiple rows of through holes, and are distributed in clearance positions between the neighboring rows in a plurality of rows of the cell sheets.

In an exemplary embodiment, the plurality of through holes form an array uniformly arranged on a plane on which the photovoltaic assembly is located.

In an exemplary embodiment, the aperture dimension of the through holes is less than the clearance dimension of each cell sheet in the cell sheet layer.

In an exemplary embodiment, a bonding layer for packaging the cell sheet layer between the two layers of the glass panels is installed between the two layers of the glass panels and the cell sheet layer, and each cell sheet in the cell sheet layer is separated from the plurality of through holes by the bonding layer.

In an exemplary embodiment, the bonding layer is an EVA layer, a polyvinyl butyral (PVB) layer or a polydimethylsiloxane (PDMS) layer.

In an exemplary embodiment, the two layers of the glass panels include a first glass panel located at one side of the cell sheet layer and a second glass panel located at the other side of the cell sheet layer, and a polyvinyl fluoride film is further installed between the cell sheet layer and the second glass panel.

In an exemplary embodiment, the outer frame of the photovoltaic assembly is directly formed by the outer frame of the two layers of the glass panels.

Based on the above technical scheme, by providing a plurality of fluid passages passing through a whole photovoltaic assembly formed by packaging a cell sheet layer by two layers of glass panels, the effect of radiating the heat of cell sheets can be achieved and the problem of overheat caused by high temperature of the photovoltaic assembly can be resolved, thereby improving the power generation efficiency and the service life of the photovoltaic assembly.

### Brief Description of the Drawings

The illustrated figures herein are used for providing further understanding to the disclosure, and form a part of the disclosure, the schematic embodiments of the disclosure and the description thereof are used for explaining the disclosure, and are not intend to limit the disclosure. In the figures:
Fig. 1 is a structural diagram of one embodiment of the disclosure photovoltaic assembly.
Fig. 2 is a structural diagram of the cell sheet layer in an embodiment of the disclosure photovoltaic assembly.
Fig. 3 is a structural diagram of another embodiment of the disclosure photovoltaic assembly.

### Detailed Description of the Embodiments

Through the accompanying drawings and the embodiments below, the technical scheme of the disclosure is further described in detail.

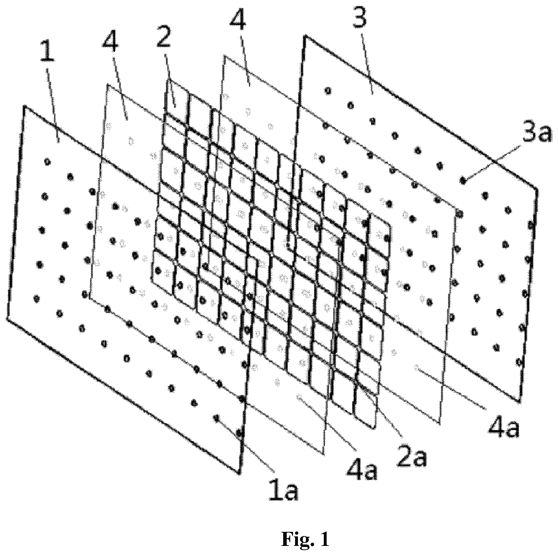

As shown in Fig. 1 is a structural diagram of an exemplary embodiment of a photovoltaic assembly in the disclosure. In the embodiment, the photovoltaic assembly includes: two layers of glass panels and a cell sheet layer 2 packaged between the two layers of glass panels, wherein a plurality of through holes is provided on the two layers of glass panels and the cell sheet layer 2, so as to form a plurality of fluid passages passing through the whole photovoltaic assembly, and at least part of the plurality of through holes are provided in clearances formed between cell sheets 21 of the cell sheet layer 2.

In order to form the fluid passages passing through the whole photovoltaic assembly, the through holes are needed to be provided in each layer of the structure of the photovoltaic assembly, one of the objectives of providing the through holes is that fluid can be conveniently flowed through, such that heat generated by the cell sheets 21 can be taken away, so the through holes are suitably provided in clearance positions between the cell sheets 21 of the cell sheet layer 2, it should be considered that the through holes also can be provided between the cell sheets and an edge of the photovoltaic assembly, so all through holes can be provided in clearance positions between the cell sheets, and provided in clearance positions between the cell sheets and clearance positions between the cell sheets and the edge of the photovoltaic assembly.

The fluid passages passing through the whole photovoltaic assembly which are formed on the photovoltaic assembly can allow a flowing gas or flowing fluid (such as air, water and oil) to pass, the fluid are used for taking away the heat generated by the cell sheets 21, achieving a cooling function of the photovoltaic assembly, and improving the generating efficiency and the service life. In addition, the fluid passages can realize a pressure-relieving function, namely in the extreme severe conditions, such as strong wind, heavy rain and heavy snow, the fluid passages can be used as pressure-relieving passages for the strong wind, the heavy rain and the heavy snow, such that air, water and snow crystal and so on can pass through the fluid passages, the accumulation is avoided and the pressure can be relieved in time, such that the photovoltaic assembly cannot be damaged because of an overlarge pressure, and the service life is not shortened.

The form of the through hole can be various forms of the through holes, such as a circular hole, a polygon hole and an elliptical hole. There are a plurality of through holes, so the good radiating and pressure-relieving functions can be obtained, and the plurality of through holes can be distributed to form multiple rows of the through holes, and distributed in clearance positions between neighboring rows in a plurality of rows of the cell sheets 21, so the normal use of the cell sheets 21 cannot be affected, and the radiating action is uniformly distributed between the cell sheets. In an exemplary embodiment, the plurality of through holes form an array uniformly arranged on a plane on which the photovoltaic assembly is located, namely a matrix layout in equal distance. For example, 45 through holes are arranged in 5*9 in Fig. 1. According to the dimension and the radiating requirement of the photovoltaic assembly, the number of rows in the array can be adjusted. About the dimension of the through holes, no matter which forms of the through holes, the exemplary dimension of the through holes is less than the clearance dimension of each cell sheet 21 of the cell sheet layer 2. It should be noted that it is not specifically herein indicated that the dimension of all through holes is less than the clearance dimension of each cell sheet 21 in the cell sheet layer 2, because the clearance dimension of each cell sheet 21 can be different, the dimension of the through hole is larger correspondingly in the position with the larger clearance dimension, and the dimension of the through hole is smaller correspondingly in the position with the smaller clearance dimension, so it should be understood that the clearance dimension in the corresponding position is related to the dimension of the through hole installed in the position.

For the polygon hole, such as a rectangular hole, a length and a width of the hole are slightly less than a distance between the neighboring cell sheets in the position, and for the circular hole, a diameter of the hole is slightly less than the distance between the neighboring cell sheets in the position. So the cell sheets cannot be intervened by the through holes.

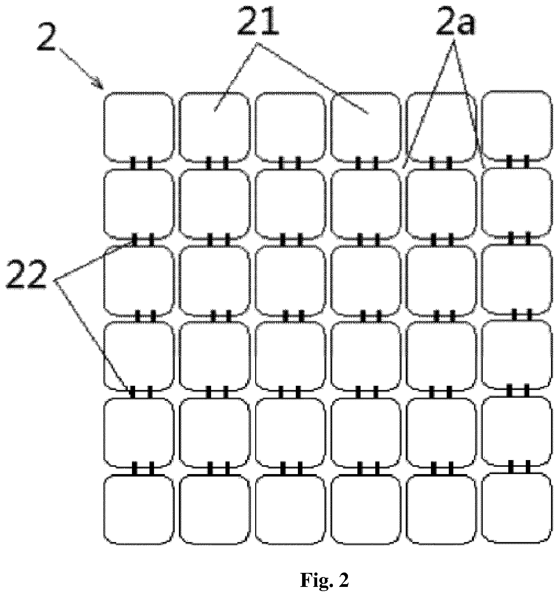

Fig. 2 shows a structure diagram of the embodiment in which a part is intercepted from the cell sheet layer 2. The cell sheet layer 2 includes a plurality of cell sheets 21 arranged according to a preset geometrical relation, there are 6*6 cell sheets 21 in Fig. 2, in each row of the cell sheets 21, a positive electrode and a negative electrode of the neighboring cell sheets are connected by a silver grid line so as to form a series connection, and the lower edges of cell modules (not shown in the figure) are parallelly connected by a bus bar so as to form a route of output. A lead is guided out from a back face of the photovoltaic assembly and is connected with a connecting box. The through holes 2a of the cell sheet layer 2 can be formed in the clearance (such as the clearance between every four neighboring cell sheets 21) formed by the cell sheets 21, according to the different forms and the different arrangement modes of the cell sheets, the through holes 2a also can be provided in the clearance between two or three cell sheets.

In the disclosure, the photovoltaic assembly is capable of packaging the cell sheet layer 2 by using two layers of the glass panels, with reference to Fig. 1, it should be observed that the two layers of the glass panels include a first glass panel 1 provided at one side of the cell sheet layer 2 and a second glass panel 3 provided at the other side of the cell sheet layer 2, wherein through holes 1a provided in the first glass panel 1 and through holes 3a provided in the second glass panel 3 correspond to through holes 2a of the cell sheet layer 2, so as to form the fluid passages passing through the whole photovoltaic assembly. In an exemplary embodiment, the first glass panel 1 and the second glass panel 3 are the tempered glass, the tempered glass can ensure the intensity and the waterproof performance of the photovoltaic assembly, and other types of the glass also can be selected according to the need. In addition, compared with the related double-glass photovoltaic assembly in which the through holes are not provided, the disclosure reduces a weight of the photovoltaic assembly through providing the through holes in the two layers of the glass panels.

In order to achieve the package to the cell sheet layer by two layers of the glass panels, a bonding layer 4 is used for packaging between the two layers of the glass panels and the cell sheet layer 2, the two layers of the glass panels and the cell sheet layer are combined through a bonding mode, so as to form a whole photovoltaic assembly. In an exemplary embodiment, the two layers of the glass panels also can package the cell sheet layer through other modes, for example, a plurality of connecting columns are provided between the two layers of the glass panels. The bonding layer 4 has a function of packaging the cell sheet layer, and can isolate each cell sheet 21 of the cell sheet layer 2 from multiple through holes 2a. The cell sheet 21 is isolated from the through holes 2a by using a bonding material, the cell sheet can be prevented from contacting with the fluid through the through holes 2a, such that the performance and the service life is reduced. The positions, corresponding to the through holes of the two layers of the glass panels and the cell sheet layer, on the bonding layer 4 are also provided with the through holes 4a, such that the photovoltaic assembly forms the fluid passages passing through the whole photovoltaic assembly.

The bonding layer 4 can use the EVA layer, such material belongs to thermoset film-like hot melt glue, while the EVA layer is heated to a certain temperature, the physical and chemical changes are generated under an action of a laminating machine, and the glass is tightly adhered to the cell sheets. After the hot melting and solidification, the EVA has the good adhesion performance, as well as the stable structure and the waterproof function. The two layers of the glass panels and the cell sheet layer bonded by using the EVA can obtain the good intensity and the waterproof performance. In addition, other thermoset film-like hot melt glue also can be used. In an exemplary embodiment, a bonding layer formed by other materials capable of realizing the adhesion also can be used, such as a thermoplastic polyvinyl butyral (PVB) layer or a polydimethylsiloxane (PDMS) layer.

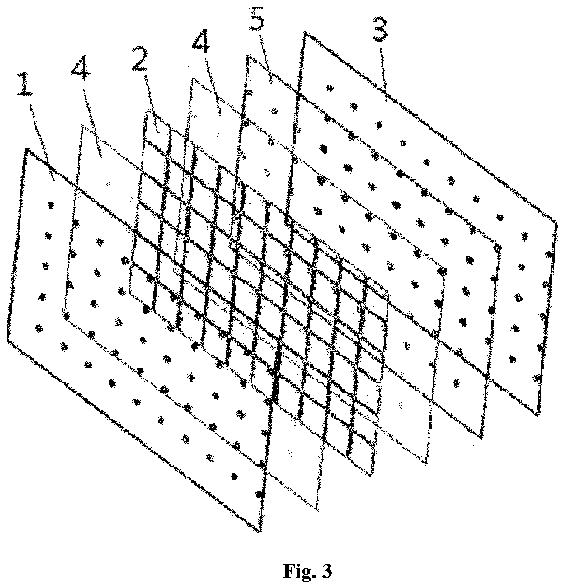

As shown in Fig. 3 is a structural diagram of another embodiment of the disclosure photovoltaic assembly. Compared with the related embodiment, a polyvinyl fluoride film 5, such as a Tedlar film, is provided between the cell sheet layer 2 and the second glass panel 3 in the embodiment, such polyvinyl fluoride film 5 can be adhered with the cell sheet layer through the bonding layer 4, and the polyvinyl fluoride film 5 and the second glass panel 3 are adhered through silica gel. The polyvinyl fluoride film 5 has the good water vapor penetrability resistance, the high intensity, the high-low temperature resistance and the good electrical property, and is capable of improving the multi-aspect performances of the photovoltaic assembly. Through holes are also provided in the polyvinyl fluoride film 5, so as to form the fluid passages passing through the whole photovoltaic assembly.

In some embodiments of the disclosure, an outer frame of the photovoltaic assembly can be directly formed by an outer frame of the two layers of the glass panels, and a frame prepared by a peripheral aluminium alloy or other metal materials is not used, because the glass is an insulator, the loss of the electrons towards the periphery can be reduced or avoided as possible, the potential induced decay (PID) effect of the photovoltaic assembly is effectively inhibited, and the generating efficiency of the photovoltaic assembly is improved.

Finally, it should be noted that the above embodiments are merely used for explaining the technical scheme of the disclosure, but not intended to limit the disclosure; although the disclosure is described in detail with reference to the better embodiments, it should be understood by those skilled in the art that the specific implementation modes of the disclosure still can be modified or the partial technical features can be replaced equivalently; and the spirit without departing from the technical scheme of the disclosure shall fall within the scope of the technical scheme protected by the disclosure.

## Claims

1. A photovoltaic assembly, comprising: two layers of glass panels and a cell sheet layer (2) packaged between the two layers of glass panels, wherein a plurality of through holes are provided on the two layers of glass panels and the cell sheet layer (2), so as to form a plurality of fluid passages passing through the photovoltaic assembly, and at least part of the plurality of through holes are provided in clearances formed between cell sheets (21) of the cell sheet layer (2).

2. The photovoltaic assembly as claimed in claim 1, wherein the plurality of through holes form multiple rows of through holes, and are distributed in clearance positions between neighboring rows in a plurality of rows of the cell sheets (21).

3. The photovoltaic assembly as claimed in claim 2, wherein the plurality of through holes form an array uniformly arranged on a plane on which the photovoltaic assembly is located.

4. The photovoltaic assembly as claimed in claim 2, wherein a aperture dimension of each through hole is less than a clearance dimension of each cell sheet (21) of the cell sheet layer (2).

5. The photovoltaic assembly as claimed in claim 1, wherein a bonding layer (4) for packaging the cell sheet layer (2) between the two layers of the glass panels is provided between the two layers of the glass panels and the cell sheet layer (2), and each cell sheet (21) of the cell sheet layer (2) is separated from the plurality of through holes by the bonding layer (4).

6. The photovoltaic assembly as claimed in claim 5, wherein the bonding layer (4) is an Ethylene Vinyl Acetate (EVA) layer, a polyvinyl butyral (PVB) layer or a polydimethylsiloxane (PDMS) layer.

7. The photovoltaic assembly as claimed in claim 1, wherein the two layers of the glass panels comprise a first glass panel (1) provided at one side of the cell sheet layer (2) and a second glass panel (3) provided at the other side of the cell sheet layer (2), and a polyvinyl fluoride film (5) is further provided between the cell sheet layer (2) and the second glass panel (3).

8. The photovoltaic assembly as claimed in claim 5, wherein an outer frame of the photovoltaic assembly is directly formed by an outer frame of the two layers of the glass panels.
